# EUROPEAN PATENT SPECIFICATION

(11) **EP 0 588 944 B1**
(45) Date of publication and mention of the grant of the patent: **02.01.2003**
(21) Application number: 92913812.1
(22) Date of filing: 05.06.1992
(51) Int. Cl.: G01S 13/75, H01L 21/447, H01L 21/56, H01L 23/06, H01Q 1/40

(54) **AN IMPROVED MINIATURE TRANSPONDER DEVICE**
VERBESSERTER MINIATURTRANSPONDER
REPONDEUR MINIATURE AMELIORE

(30) Priority: 05.06.1991 US 710786; 05.11.1991 US 787828
(43) Date of publication of application: 30.03.1994
(73) Proprietor: Algernon Promotions, Inc., Panama 5 (PA)
(72) Inventor: ZIRBES, Glen, Leo, Silver Lake, MN 55381 (US); HADDEN, Leonard, D., Minneapolis, MN 55409 (US)
(74) Representative: Witte, Alexander, Dr.-Ing.
(86) International application number: PCT/US92/04731
(87) International publication number: WO 92/022827

(56) References cited:
- WO-A-86/00498
- WO-A-90/14736
- NL-A- 9 001 777
- US-A- 4 263 606
- US-A- 4 273 859
- US-A- 4 695 926
- US-A- 4 733 289
- US-A- 4 911 217
- US-A- 4 992 794

## Description

The invention relates to a method of manufacturing an encapsulated miniature transponder, including directly connecting wire leads to an integrated circuit device of the transponder apparatus.

The invention, further, relates to a miniature integrated circuit transponder device comprising electromagnetic antenna means connected to an integrated circuit by lead wires.

A method and a device of the afore-mentioned kind are known from document WO 87/04900.

Generally, the present invention relates to the manufacture of miniature electronic devices and more particularly to a method and apparatus for facilitating the attachment of electro-magnetic antenna wire leads to an integrated circuit chip used in a miniature transponder device suitable for use in a wide variety of applications including implantation in a living animal. This invention further relates to a method of protecting the miniature transponder.

Document US-A-5 025 550 discloses miniature passive transponders of the type used for object identification, and particularly those which are implantable into living creatures, such as livestock. These transponders are very small and have inherent size restrictions that must be considered in their design and manufacture. Most such devices include a wire-wound electromagnetic antenna electrically connected to an integrated circuit which, in response to received transmitted energy obtained from the antenna, generates a response signal which is retransmitted to and through the antenna to a nearby sensor.

Heretofore, the integrated circuit was first mounted to a metal leadframe, potted, and then the potted device having leadframe leads extending therefrom was attached to the antenna by bonding the antenna wires to the leads. The necessity of providing a leadframe and assembling the semiconductor die to the leadframe not only adds to the cost of the device but also has a substantial bearing on the minimum size to which a particular device may be reduced.

In addition, it is necessary to protect the passive transponder from exterior factors such as corrosive environments and mechanically destructive impacts. This is particularly so when the transponder is small and delicate.

Further, it is known from EP-A-0 252 429 to provide for improved cooling of a field effect transistor (FET). Gate, drain and source of the transistor are provided on a substrate and extend, in the same plane on said substrate, to enlarged contact areas. An additional protective isolation layer is deposited on the surface of said integrated circuit device, wherein apertures are opened in said layer to expose said contact areas. A metallic layer is then deposited on the apertures, overlapping peripheral regions thereof. The metal layer may consist of two layers made of titanium tungsten and gold, respectively. A gold bump is then formed on the metallic layer providing an enlarged contact portion to which conductive beams are welded. The beams are, at their opposite ends, connected to conductive strips. Further, a gold block is provided over gate, drain, source of FET so as to allow dissipation of heat produced by the FET. Of course, no apertures are formed under this gold block.

The integrated circuit known from EP-A-0 252 429 is not particularly designed for transponders and is complicated to manufacture as the beams must be cut and then connected to the gold bumps at one end and to the conductive strips at their opposite end. Further, the insulative layer must be thin in order to allow sufficient heat conduction to the gold block formed over the FET.

Document US-A-4 263 606 discloses a method of forming an external connection structure for an integrated semiconductor device. An insulator layer covers a wiring layer of the device and is provided with apertures. A metallic film lines the aperture, forming a recess. A bump is disposed in the recess. The bump is spaced from side walls of the recess.

Document WO 87/04900, mentioned at the outset, discloses a related type of transponder wherein wire leads are attached to the pads of a semiconductor die using prior art techniques. The leads are attached to the standard contact pads being small squares positioned at the distal ends of the wires. The small contact pads are standard circuit contact pads in the sense of the present invention.

Considering in general the prior art of transponders in question, it is exactly because of the small and delicate nature of such transponders that adequate protection is not easy to apply. The need is, therefore, for a simple and efficient means for protecting the transponder which, when the protection is applied, does not harm the transponder in any way.

According to the method, specified at the outset, the afore-mentioned objects are achieved by providing external contact pads to an integrated circuit device, comprising the steps of
- depositing an additional layer of insulating material over the surface of the integrated circuit device, said additional insulative layer having a thickness in excess of 10,000 angstroms (1 µm);
- opening apertures in said insulative layer to expose standard circuit contact pads of said device; and
- forming a conductive body of metal overlying each said aperture and covering a surrounding surface area of said insulative layer substantially larger than that of said underlying apertures, each said conductive body ohmically communicating with the corresponding standard contact pad through the corresponding aperture to provide an enlarged external contact pad to which the leads may be connected, and by
directly bonding the wire lead (16) to said enlarged contact pad, the thickness of said additional layer and the size and thickness of said conductive body being sufficient to protect said integrated circuit during the bonding of said wire lead to said external contact pad.

Further, according to the miniature integrated circuit transponder, specified at the outset, the afore-mentioned objects are achieved by:
- a semiconductor substrate having an integrated circuit formed thereon, said integrated circuit including a plurality of discrete contact pads for facilitating electrical interconnection thereto;
- an electrically insulative layer covering said integrated circuit and having apertures formed therein exposing said contact pads, said electrically insulative layer having a thickness in excess of 10,000 anstroms (1 µm) ;
- a plurality of bonding pads disposed over said insulative layer, with each said bonding pad extending through one of said apertures to make electrical contact with one of said contact pads, each said bonding pad having a surface area overlying a portion of said insulative layer substantially larger than the area of its corresponding aperture,
- said electromagnetic antenna means having lead wires directly bonded to corresponding ones of said bonding pads, the size and thickness of said bonding pads and said insulative layer being sufficient to protect said substrate and said integrated circuit during the bonding of said lead wires to said bonding pads.

An important advantage of the present invention is that it reduces the cost and size of a passive transponder device.

Another advantage of the present invention is that it makes possible visible inspection of all circuit connections.

These and other advantages of the present invention will no doubt become apparent to those skilled in the art after having read the following detailed description of the preferred embodiment which is illustrated in the several figures of the drawing.
Fig. 1 is a perspective view illustrating an encapsulated transponder apparatus according to one application of the present invention;
Fig. 2 is a perspective view more clearly illustrating a preferred embodiment of the present invention;
Fig. 3 is a transverse cross-section taken in the plane 3-3 of Fig. 2; and
Figs. 4 and 5 illustrate the method of protecting the transponder apparatus of Fig. 1.

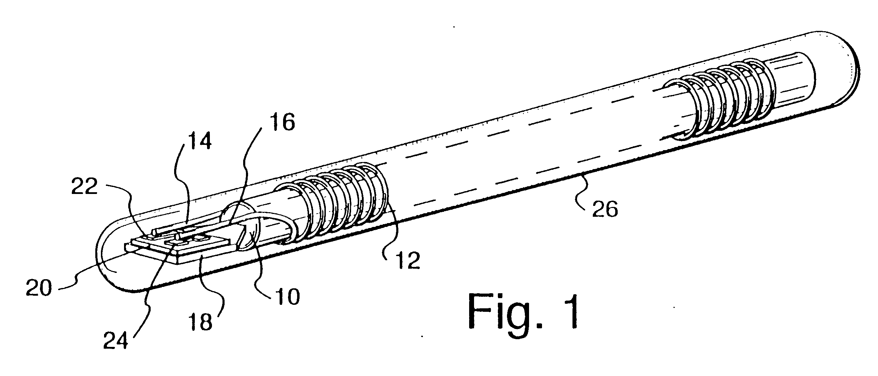

Referring now to Fig. 1 of the drawing, there is shown a small implantable microtransponder device of the type generally described in document US-A-5 025 550 but incorporating the present invention.

More specifically, the illustrated device includes an electromagnetic antenna formed of an elongated cylindrical magnetic core 10 having a length of ultra-fine conductive wire 12 wrapped thereabout with the ends 14 and 16 extending forwardly. One such antenna is disclosed in document WO 90/14736. Affixed to the end of core 10 is a support means 18 to which is attached an integrated circuit die 20 having a pair of contact pads 22 and 24 provided thereon in accordance with the present invention. As depicted, the wire end 14 is conductively bonded to pad 22, and the wire end 16 is conductively bonded to pad 24. For some applications it may be possible to dispense with the support means 18 and depend entirely upon the wires 14 and 16 for support prior to subsequent encapsulation. Bonding is preferably effected by thermal compression.

Note that since the pads 22 and 24 are installed during the wafer fabrication process, the only post-fabrication testing that need be undertaken is that relating to the bonding of wires 14 and 16 to the pads 22 and 24, respectively, and this can be easily accomplished using automated test equipment. In other words, the usual testing of chip-to-leadframe connection has been eliminated. After assembly and test, the transponder assembly is encapsulated in a suitable glass or plastic capsule 26 and is at this point ready for implantation in an animal or other object to be identified.

As described in document US-A-5 025 550, the die 20 includes electronic memory and associated modulation circuitry such that in response to power input thereto from the coil 12 generates an identifying signal which is returned to coil 12 for retransmission to a detecting antenna.

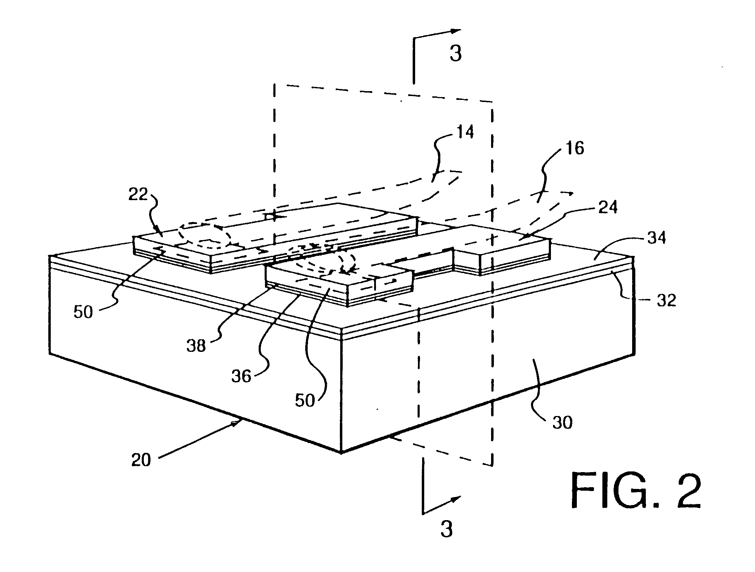

Turning now to Fig. 2 of the drawing, the die 20 is shown in enlarged detail to include a semiconductive substrate 30 having a standard phosphorus-doped glass layer 32 deposited thereon which is overcovered by a second layer of silicon nitride insulation 34 applied by plasma-enhanced deposition. The thickness of layer 34 is at least 15,000 angstroms (1,5 µm) and provides both insulation and structural protection of the underlying die. After deposition, the layer 34 is masked and two contact areas or holes 50 are etched through the layers 32 and 34 to contact the ac+ and ac- pads (not shown) on the circuit contained in die 20 beneath layer 32. With the contact areas open, the wafer is ready for the fabrication of the enhanced contact pads 22 and 24. The process starts with the deposition of a field metal layer 36 of TiW (approximately 90 % Ti and 10 % W) having a thickness of approximately 2,000 angstroms (0,2 µm). On top of this layer a layer 38 of pure gold of approximately 1,200 angstroms (0,12 µm) is deposited.

The enhanced contact pads 22 and 24 are then deposited to a thickness of approximately 25 microns (25 µm) of gold or copper. For the particular application illustrated, the pads 22 and 24 are approximately 16 milli-inches (0,4064 mm) long and 6 milli-inches (0,1524 mm) wide and provide adequate surface area to which the fine copper wires 14 and 16 may be attached by soldering, thermal compression bonding or welding. It should be noted that the thick silicon nitride layer 34 is of particular importance to the invention in that the pads 22 and 24 are plated directly over the active circuit area, i.e. the layer 34 serves to protect against damage to the underlying circuitry during the wire lead attachment process which would otherwise render the assmebly useless.

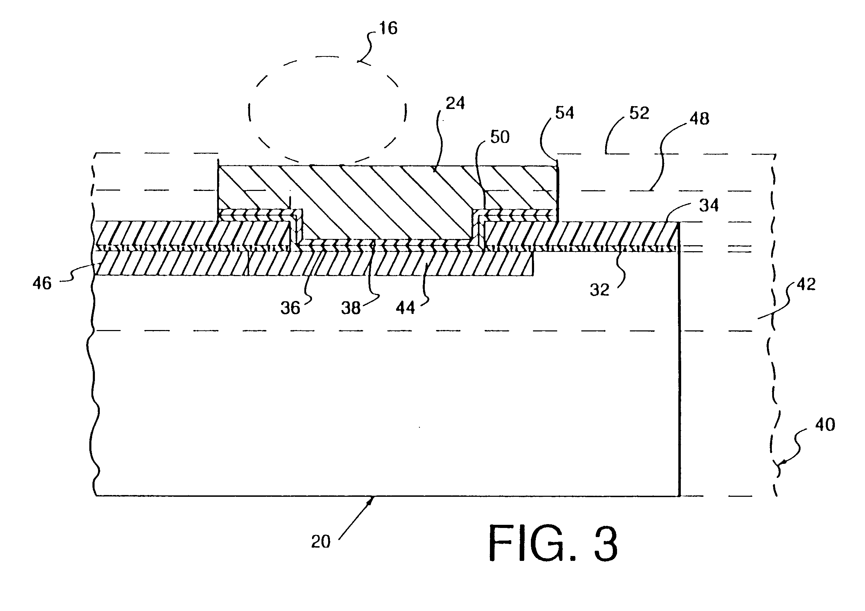

Referring now to Fig. 3 of the drawing, which is a partially broken cross-section taken along the plane 3-3 of Fig. 2, the manufacturing process is further illustrated, it being understood of course that the illustrated die is not fabricated individually but is made jointly with other die, forming a silicon wafer. After fabrication and test, the die 20 is separated from the other die of the wafer. As depicted, the wafer 40 from which the die 20 is cut forms a substrate, the upper portion 42 of which has integrated circuit components formed therein. Deposited on the usual upper surface of the wafer 40 and forming a standard electrical interconnect pad 44 is a metallization layer 46. A supporting leadframe is normally electronically connected to pads 44 by fine wires. However, in accordance with the present invention, no such leadframe and connecting wires are required and instead, as described above, after the wafer 40 is covered with the standard phosphorus-doped glass layer 32, it is then covered by a thick extra layer of silicon nitride insulation 34. The wafer is then covered with a layer of photoresist 48, and holes 50 are opened above each pad 44 (as suggested above, there are two for each die) to expose the standard contact pads 44.

After the pads 44 are open, the field metal layers 36 and 38 are deposited, typically using a DC-diode sputtering process. Thereafter, a second layer 52 of photoresist of about 30 microns (30 µm) thickness is deposited over the wafer 40, and openings 54 are formed therein to define the boundaries of the enhanced pads 22 and 24. Subsequently the 25 micron (25 µm) thick enhanced pads 22 and 24 are electroplated onto the field metal. The photoresist is then removed, and the dies are severed from the wafer 40 to yield the structure illustrated in Fig. 2. It will be understood of course that testing can be accomplished either before the dies are separated or afterwards.

Thereafter the die may be bonded to a support plate 18, as depicted in Fig. 1, and the leads 14 and 16 are attached to the enhanced pads 22 and 24, respectively, by soldering, thermal compression bonding or welding. It will be appreciated that, although the wire attachment operation is made directly to a component part of the die, i.e. the enhanced pads 24 and 26 rather than to leadframes, as described in document US-A-5 025 550, the underlying circuit is protected by a combination of the layer 34 and the structural characteristics of the pads 24 and 26.

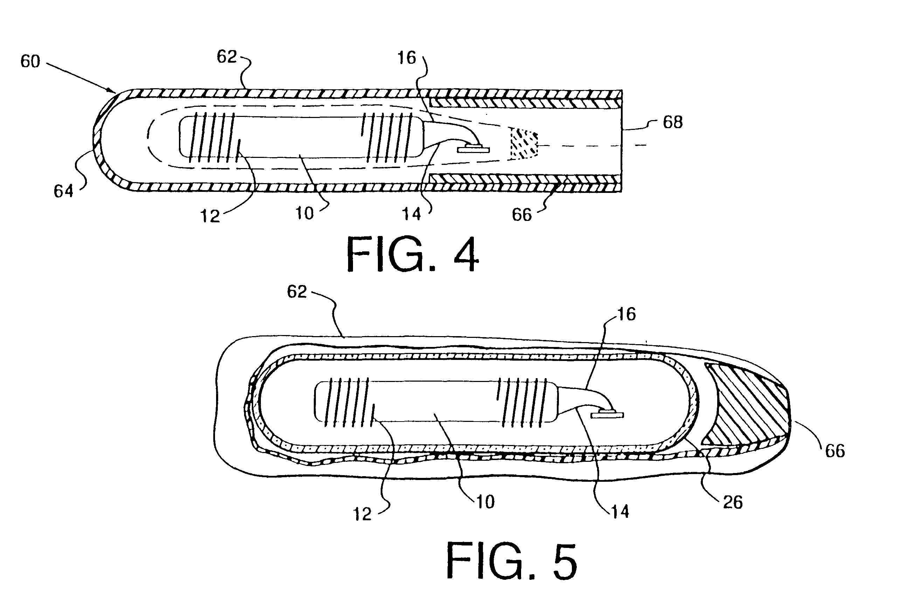

In Fig. 4 an encapsulated transponder device is generally indicated as 60. Numerals 10, 12, 14 and 16 refer to the corresponding elements of the transponder referred to in the previous figures. The transponder 60 is located within a tube 62 which has been preformed with one end closed at 64. Insertion of the transponder 60 into the tube 62 can be accomplished by any suitable mechanical placing means .

The tube 62 is made of a heat shrinkable material such as heat shrinkable polyvinylidene fluoride. In addition, the inside surface of the tube 62 may be partially or fully coated with a thermal plastic 66. In the event that the encapsulated transponder 60 is to be inserted into a living body, the heat shrinkable material 66 would need to be inert or further coated by an inert material.

Once the transponder 60 is positioned within the tube 62 heat is applied to the tubing which then shrinks around and protects the transponder 60. The thermal plastic 66, when subjected to heat, softens and flows to seal the open end 68 of the tube 62. As a result of this procedure, the transponder 60 is encapsulated within a rigid and durable plastic container and is entirely sealed off, partially by the thermal plastic 66 and partially by the heat shrunk tube 62, from adverse environmental influences. The post shrinking format of the tube 62 and thermal plastic 66 is shown in broken lines in Fig. 4.

Although the use of the heat shrink plastic is known for encapsulating electronic devices (documents US-A-3 603 720 and 4 695 926), the prior art encapsulated devices have leads protruding therefrom which makes hermetic encapsulation very difficult. The transponder 60 of the invention has no leads protruding beyond the outer extremities of the tube 62 and this feature together with the use of a thermal plastic 66 makes this advantageous encapsulation of the transponder 60 a non-obvious application of the heat shrinking plastics technology.

Turning now to Fig. 5 it will be seen that the transponder 60 in this case is located within a glass capsule 26 very much the same as illustrated in Fig. 1. In this Fig. 5, the transponder 60 together with the capsule 26 has been inserted within a heat shrinkable tube 62. As illustrated, the tube 62 has already been shrunk and the thermal plastic has flowed to form a plug 70 at what was the open end 68 of the tube 62. The choice of encapsulating the transponder 60 in only a heat shrink plastic 66 or a combination of glass capsule 26 and heat shrink plastic 66 will depend on the specific uses that the device needs to be put to.

The advantage of using this method of protecting the transponder 60 lies in that it is technically complex to use conventional plastic molding techniques to mold a plastic envelope around the transponder. This is because it is difficult to hold the transponder in the center of the mold cavity, which is necessary to achieve an adequate plastic wall thickness about the transponder. Insertion of the transponder into a preferred heat shrinkable plastics tube avoids these difficulties.

Furthermore, the transponder device referred to in this description could be as small as 10 mm in length and 1,5 mm in diameter. This very small size makes the transponder extremely delicate and difficult to work with and effectively prevents the use of any encapsulation techniques that will damage it. The method of this invention is very well suited to encapsulation of a transponder such as this.

Although the present invention has been described in terms of an embodiment particularly suited for use in the fabrication of a microtransponder device, the same process can be used to make devices for a wide variety of applications.

Furthermore, although the present invention has been described above in terms of a single preferred embodiment, it is anticipated that numerous alterations and modifications thereof will become apparent to those skilled in the art.

## Claims

1. A method of manufacturing an encapsulated miniature transponder apparatus (60), including directly connecting wire leads (14, 16) to an integrated circuit device (20) of said transponder apparatus (60), **characterized by**
providing external contact pads (22, 24) to the integrated circuit device (20), comprising the steps of:
- depositing an additional layer (34) of insulating material over the surface of said integrated circuit device (20), said additional insulative layer having a thickness in excess of 10,000 angstroms (1 µm),
- opening apertures (50) in said insulative layer (34) to expose standard circuit contact pads (44) of said device (20), and
- forming a conductive body of metal overlying each said aperture (50) and covering a surrounding surface area of said insulative layer (34) substantially larger than that of said underlying apertures (50), each said conductive body ohmically communicating with the corresponding standard contact pad (44) through the corresponding aperture (50) to provide an enlarged external contact pad (24) to which the leads (14, 16) may be connected; and by
directly bonding the wire lead (14, 16) to said enlarged external contact pad (24), the thickness of said additional layer (34) and the size and thickness of said conductive body being sufficient to protect said integrated circuit (20) during the bonding of said wire lead (14, 16) to said external contact pad (24).

2. The method of claim 1, **characterized in that** said external contact pads (24) are formed by first depositing field metal (36, 38) in electrical connection with said standard pads (44) and plating said conductive bodies of metal directly thereover.

3. The method of claim 1 or 2, **characterized in that** said additional insulative layer is a layer of silicon nitride.

4. The method of any of claims 1 - 3, **characterized in that** said external contact pads (24) are made of a metal selected from the group consisting of gold or copper, and have a thickness of at least 20 microns (20 µm).

5. The method of any of claims 1 - 4, **characterized in that** the wire leads (14, 16) of a miniature antenna (10, 12) are bonded to the external contact pads (22, 24) to form a transponder (60) which is first encapsulated in a glass capsule (26) and thereafter in heat-shrinkable material (66).

6. The method of claim 5, **characterized in that** the heat-shrinkable material (66) is, before being applied to encapsulate the transponder (60), in the form of a hollow tube (62) which is closed at one end (64).

7. The method of claim 6, **characterized in that** the tube (62) is made of a thermal plastic which, when heat is applied to the tube (62), flows to seal the open end (68) of the tube (62).

8. The method of any of claims 1 - 7, **characterized in that** the wire leads (14, 16) are bonded to said enlarged external contact pad (24) by thermal compression bonding.

9. A miniature integrated circuit transponder device (60) comprising electromagnetic antenna means (10, 12) connected to an integrated circuit (20) by lead wires (14, 16), **characterized by**
- a semiconductor substrate (30) having an integrated circuit (20) formed thereon, said integrated circuit (20) including a plurality of discrete contact pads (44) for facilitating electrical interconnection thereto;
- an electrically insulative layer (34) covering said integrated circuit (20) and having apertures (50) formed therein exposing said contact pads (44), said electrically insulative layer (34) having a thickness in excess of 10,000 angstroms (1 µm); and
- a plurality of bonding pads (22, 24) disposed over said insulative layer (34), with each said bonding pad (22, 24) extending through one of said apertures (50) to make electrical contact with one of said contact pads (44), each said bonding pad (22, 24) having a surface area overlying a portion of said insulative layer (34) substantially larger than the area of its corresponding aperture (50);
- said electromagnetic antenna means (10, 12) having lead wires (14, 16) directly bonded to corresponding ones of said bonding pads (22, 24), the size and thickness of said bonding pads (22, 24) and said insulative layer (34) being sufficient to protect said substrate (30) and said integrated circuit (20) during the bonding of said lead wires (14, 16) to said bonding pads (22, 24).

10. The transponder device of claim 9, **characterized in that** said lead wires (14, 16) of said antenna means (10, 12) are bonded to corresponding ones of said bonding pads (22, 24) by thermal compression bonding.

11. The transponder device of claim 9 or 10, **characterized in that** the thickness of said bonding pads (22, 24) is in excess of 20 microns (20 µm).

12. The transponder device of any of claims 9 - 11, **characterized by** a further insulative layer (32) formed over said substrate (30) to protect said integrated circuit (20) and said contact pads (44), said insulative layer (34) covering said further insulative layer (32), said further insulative layer (32) having apertures (50) therein exposing said contact pads (44).

13. The transponder device of any of claims 9 - 12, **characterized in that** said lead wires (14, 16) are thermal compression bonded to their corresponding bonding pads (22, 24).

14. The transponder device of any of claims 9 - 13, **characterized in that** said semiconductor substrate (30) is supported by said lead wires (14, 16).

15. The transponder device of any of claims 9 - 13, **characterized in that** said semiconductor substrate (30) is supported by support means (18) attached to said electromagnetic antenna means (10, 12).

16. The transponder device of any of claims 9 - 15, **characterized by** encapsulating means (62, 66) commonly encapsulating said integrated circuit (20), said insulating layer (34), said bonding pads (22, 24) and said antenna means (10, 12) to form the transponder device (60).

17. The transponder device of any of claims 9 - 16, **characterized in that** the bonding pads (22, 24) are made of a metal selected from the group consisting of gold or copper.

## Patentansprüche

1. Verfahren zum Herstellen einer verkapselten, miniaturisierten Transpondervorrichtung (60), einschließlich des Schrittes, Anschlußdrähte (14, 16) direkt mit einer integrierten Schaltungseinrichtung (20) der Transpondervorrichtung (60) zu verbinden, **gekennzeichnet durch** die Schritte
Bereitstellen von externen Kontaktpads (22, 24) an der integrierten Schaltungseinrichtung (20), mit den Schritten:
- Abscheiden einer zusätzlichen Schicht (34) aus einem isolierenden Material auf der Oberfläche der integrierten Schaltungseinrichtung (20), wobei die zusätzliche Isolierschicht eine Dicke von mehr als 10.000 Angström (1 µm) aufweist,
- Ausbilden von Öffnungen (50) in der Isolierschicht (34), um Standardkontaktpads (44) der Schaltungseinrichtung (20) freizulegen, und
- Bilden eines leitenden Metallstückes, das jeweils über einer der Öffnung (50) liegt und einen umgebenden Oberflächenbereich der Isolierschicht (34) abdeckt, der wesentlich größer ist als jener der darunterliegenden Öffnungen (50), wobei jedes leitende Stück mit dem entsprechenden Standardkontaktpad (44) über die entsprechende Öffnung (50) ohmisch in Verbindung steht, so daß ein vergrößerter externer Kontaktpad (24) bereitgestellt wird, mit dem die Anschlüsse (14, 16) verbunden werden können; und
direktes Bondieren des Anschlußdrahtes (14, 16) auf den vergrößerten externen Kontaktpad (24), wobei die Dicke der zusätzlichen Schicht (34) und die Größe und die Dicke des leitenden Stückes hinreichend sind, um die integrierte Schaltung (20) während des Bondierens des Anschlußdrahtes (14, 16) an den externen Kontaktpad (24) zu schützen.

2. Verfahren nach Anspruch 1, **dadurch gekennzeichnet, daß** die externen Kontaktpads (24) gebildet werden, indem zunächst Feldmetall (36, 38) in elektrischer Verbindung mit den Standardpads (44) abgeschieden wird und die leitenden Metallstücke direkt hierauf plattiert werden.

3. Verfahren nach Anspruch 1 oder 2, **dadurch gekennzeichnet, daß** die zusätzliche Isolierschicht eine Schicht aus Siliziumnitrid ist.

4. Verfahren nach einem der Ansprüche 1 bis 3, **dadurch gekennzeichnet, daß** die externen Kontaktpads (44) aus einem Metall hergestellt sind, das aus der Gruppe ausgewählt ist, die aus Gold und Kupfer besteht, und eine Dicke von wenigstens 20 Mikron (20 µm) aufweisen.

5. Verfahren nach einem der Ansprüche 1 bis 4, **dadurch gekennzeichnet, daß** die Anschußdrähte (14, 16) einer miniaturisierten Antenne (10, 12) an die externen Kontaktpads (22, 24) bondiert werden, um einen Transponder (60) zu bilden, der zuerst in einer Glaskapsel (26) und hiernach in einem wärmeschrumpffähigen Material (66) verkapselt wird.

6. Verfahren nach Anspruch 5, **dadurch gekennzeichnet, daß** das wärmeschrumpffähige Material (66) in der Form eines hohlen Schlauches bzw. Rohres (62), das an einem Ende (64) geschlossen ist, vorliegt, bevor es zum Verkapseln des Transponders (60) angelegt wird.

7. Verfahren nach Anspruch 6, **dadurch gekennzeichnet, daß** das Rohr (62) aus einem thermischen Kunststoff hergestellt ist, der beim Anlegen von Wärme an das Rohr (62) fließt, wobei er das offene Ende (68) des Rohrs (62) abdichtet.

8. Verfahren nach einem der Ansprüche 1 bis 7, **dadurch gekennzeichnet, daß** die Anschlußdrähte (14, 16) durch Thermokompressionsbondierung an die vergrößerten externen Kontaktpads (24) bondiert werden.

9. Miniaturisierte Transpondervorrichtung (60) mit integrierter Schaltung, wobei die Transpondervorrichtung (60) elektromagnetische Antennenmittel (10, 12) aufweist, die mittels Anschußdrähten (14, 16) mit einer integrierten Schaltung (20) verbunden sind, **gekennzeichnet durch**:
- ein Halbleitersubstrat (30) mit einer darauf gebildeten integrierten Schaltung (20), wobei die integrierte Schaltung (20) eine Vielzahl von diskreten Kontaktpads (44) aufweist, um elektrische Verbindungen mit der Schaltung zu erleichtern bzw. zu ermöglichen;
- eine elektrisch isolierende Schicht (34), die die integrierte Schaltung (20) bedeckt und Öffnungen (50) darin aufweist, die die Kontaktpads (44) freilegen, wobei die elektrisch isolierende Schicht (34) eine Dicke von über 10.000 Angström (1 µm) aufweist; und
- eine Vielzahl von Bondierungspads (22, 24), die über der isolierenden Schicht (34) angeordnet sind, wobei jeder der Bondierungspads (22, 24) sich **durch** eine der Öffnungen (50) erstreckt, um einen elektrischen Kontakt mit einem der Kontaktpads (44) herzustellen, wobei jeder der Bondierungspads (22, 24) einen Oberflächenbereich aufweist, der über einem Abschnitt der isolierenden Schicht (34) liegt, der wesentlich größer ist als die Fläche bzw. der Bereich der entsprechenden Öffnung (50);
- wobei die elektromagnetischen Antennenmittel (10, 12) Anschlußdrähte (14, 16) aufweisen, die direkt an entsprechende Bondierungspads (22, 24) bondiert sind, wobei die Größe und die Dicke der Bondierungspads (22, 24) und der isolierenden Schicht (34) hinreichend sind, um das Substrat (30) und die integrierte Schaltung (20) während des Bondierens der Anschlußdrähte (14, 16) an die Bondierungspads (22, 24) zu schützen.

10. Transpondervorrichtung nach Anspruch 9, **dadurch gekennzeichnet, daß** die Anschlußdrähte (14, 16) der Antennenmittel (10, 12) durch Thermokompressionsbondierung an entsprechende Bondierungspads (22, 24) bondiert sind.

11. Transpondervorrichtung nach Anspruch 9 oder 10, **dadurch gekennzeichnet, daß** die Dicke der Bondierungspads (22, 24) 20 Mikron (20 µm) übersteigt.

12. Transpondervorrichtung nach einem der Ansprüche 9 bis 11, **gekennzeichnet durch** eine weitere isolierende Schicht (32), die über dem Substrat (30) ausgebildet ist, um die integrierte Schaltung (20) und die Kontaktpads (44) zu schützen, wobei die isolierende Schicht (34) die weitere isolierende Schicht (32) bedeckt, wobei die weitere isolierende Schicht (32) Öffnungen (50) darin aufweist, die die Kontaktpads (44) freilegen.

13. Transpondervorrichtung nach einem der Ansprüche 9 bis 12, **dadurch gekennzeichnet, daß** die Anschlußdrähte (14, 16) an ihre entsprechenden Bondierungspads (22, 24) thermokompressions-bondiert sind.

14. Transpondervorrichtung nach einem der Ansprüche 9 bis 13, **dadurch gekennzeichnet, daß** das Halbleitersubstrat (30) durch die Anschlußdrähte (14, 16) gelagert ist.

15. Transpondervorrichtung nach einem der Ansprüche 9 bis 13, **dadurch gekennzeichnet, daß** das Halbleitersubstrat (30) durch Lagermittel (18) gelagert ist, die an den elektromagnetischen Antennenmitteln (10, 12) angebracht sind.

16. Transpondervorrichtung nach einem der Ansprüche 9 bis 15, **gekennzeichnet durch** Verkapselungsmittel (62, 66), die die integrierte Schaltung (20), die isolierende Schicht (34), die Bondierungspads (22, 24) und die Antennenmittel (10, 12) gemeinsam verkapseln, um die Transpondervorrichtung (20) zu bilden.

17. Transpondervorrichtung nach einem der Ansprüche 9 bis 16, **dadurch gekennzeichnet, daß** die Bondierungspads (22, 24) aus einem Metall hergestellt sind, das aus der Gruppe ausgewählt ist, die aus Gold und Kupfer besteht.

## Revendications

1. Procédé de fabrication d'un dispositif répondeur miniature encapsulé (60), comprenant le fait de connecter directement des fils conducteurs (14, 16) à un dispositif à circuit imprimé (20) dudit dispositif répondeur (60), **caractérisé par**
le fait de prévoir des plages de contact externes (22, 24) pour le dispositif à circuit intégré (20), comprenant les étapes consistant à :
- déposer une couche supplémentaire (34) de matériau isolant sur la surface dudit dispositif à circuit imprimé (20), ladite couche isolante supplémentaire ayant une épaisseur supérieure à 10 000 angströms (1 µm),
- aménager des ouvertures (50) dans ladite couche isolante (34) pour mettre à nu des plages de contact de circuit standards (44) dudit dispositif (20), et
- former un corps conducteur en métal chevauchant chaque ouverture (50) et couvrant une surface environnante de ladite couche isolante (34) sensiblement plus étendue que la surface desdites ouvertures sous-jacentes (50), chaque corps conducteur communiquant de façon ohmique avec la plage de contact standard (44) correspondante par l'intermédiaire de l'ouverture correspondante (50) pour former une plage de contact externe agrandie (24) à laquelle les conducteurs (14, 16) peuvent être connectés ; et **caractérisé par** le fait de
lier directement le fil conducteur (14, 16) à ladite plage de contact externe agrandie (24), l'épaisseur de ladite couche supplémentaire (34) et la taille et l'épaisseur dudit corps conducteur étant suffisantes pour protéger ledit circuit intégré (20) pendant la liaison dudit fil conducteur (14, 16) à ladite plage de contact externe (24).

2. Procédé selon la revendication 1, **caractérisé en ce que** lesdites plages de contact externes (24) sont formées en déposant d'abord un métal de champ (36, 38) en liaison électrique avec lesdites plages standards (44) et en plaquant lesdits corps conducteurs en métal directement par-dessus.

3. Procédé selon la revendication 1 ou 2, **caractérisé en ce que** ladite couche isolante supplémentaire est une couche de nitrure de silicium.

4. Procédé selon l'une quelconque des revendications 1 à 3, **caractérisé en ce que** lesdites plages de contact externes (24) sont fabriquées dans un métal choisi dans le groupe constitué de l'or ou du cuivre, et ont une épaisseur d'au moins 20 microns (20 µm).

5. Procédé selon l'une quelconque des revendications 1 à 4, **caractérisé en ce que** les fils conducteurs (14, 16) d'une antenne miniature (10, 12) sont liés aux plages de contact externes (22, 24) pour former un répondeur (60) qui est d'abord encapsulé dans une capsule de verre (26), puis dans un matériau thermorétractable (66).

6. Procédé selon la revendication 5, **caractérisé en ce que** le matériau thermorétractable (66), avant d'être appliqué pour encapsuler le répondeur (60), est de la forme d'un tube creux (62) qui est fermé à une extrémité (64).

7. Procédé selon la revendication 6, **caractérisé en ce que** le tube (62) est fabriqué en une matière plastique qui, lorsque de la chaleur est appliquée au tube (62), s'écoule pour sceller l'extrémité ouverte (68) du tube (62).

8. Procédé selon l'une quelconque des revendications 1 à 7, **caractérisé en ce que** les fils conducteurs (14, 16) sont liés à ladite plage de contact externe agrandie (24) par liaison par compression thermique.

9. Dispositif répondeur miniature à circuit intégré (60) comprenant des moyens formant antenne électromagnétique (10, 12) reliés à un circuit intégré (20) par des fils conducteurs (14, 16), **caractérisé par**
- un substrat semi-conducteur (30) ayant un circuit intégré (20) formé sur lui, ledit circuit intégré (20) comprenant une pluralité de plages de contact discrètes (44) pour faciliter une interconnexion électrique avec lui ;
- une couche isolante électrique (34) couvrant ledit circuit intégré (20) et ayant des ouvertures (50) formées en elle, mettant à nu lesdites plages de contact (44), ladite couche isolante électrique (34) ayant une épaisseur supérieure à 10 000 angströms (1 µm) ; et
- une pluralité de plages de liaison (22, 24) disposées sur ladite couche isolante (34), chaque plage de liaison (22, 24) s'étendant à travers l'une desdites ouvertures (50) pour établir un contact électrique avec l'une desdites plages de contact (44), chaque plage de liaison (22, 24) ayant une surface chevauchant une partie de ladite couche isolante (34) d'une étendue sensiblement plus importante que la surface de son ouverture correspondante (50) ;
- lesdits moyens formant antenne électromagnétique (10, 12) ayant des fils conducteurs (14, 16) liés directement à certaines correspondantes desdites plages de liaison (22, 24), la taille et l'épaisseur desdites plages de liaison (22, 24) et de ladite couche isolante (34) étant suffisantes pour protéger ledit substrat (30) et ledit circuit intégré (20) pendant la liaison desdits fils conducteurs (14, 16) auxdites plages de liaison (22, 24).

10. Dispositif répondeur selon la revendication 9, **caractérisé en ce que** lesdits fils conducteurs (14, 16) desdits moyens formant antenne (10, 12) sont liés à certaines correspondantes desdites plages de liaison (22, 24) par liaison par compression thermique.

11. Dispositif répondeur selon la revendication 9 ou 10, **caractérisé en ce que** l'épaisseur desdites plages de liaison (22, 24) est supérieure à 20 microns (20 µm).

12. Dispositif répondeur selon l'une quelconque des revendications 9 à 11, **caractérisé par** une autre couche isolante (32) formée sur ledit substrat (30) pour protéger ledit circuit intégré (20) et lesdites plages de contact (44), ladite couche isolante (34) couvrant ladite couche isolante supplémentaire (32), ladite couche isolante supplémentaire (32) ayant des ouvertures en elles pour mettre à nu lesdites plages de contact (44).

13. Dispositif répondeur selon l'une quelconque des revendications 9 à 12, **caractérisé en ce que** lesdits fils conducteurs (14, 16) sont liés par compression thermique à leurs plages de liaison correspondantes (22, 24)

14. Dispositif répondeur selon l'une quelconque des revendications 9 à 13, **caractérisé en ce que** ledit substrat semi-conducteur (30) est porté par lesdits fils conducteurs (14, 16).

15. Dispositif répondeur selon l'une quelconque des revendications 9 à 13, **caractérisé en ce que** ledit substrat semi-conducteur (30) est porté par des moyens support (18) fixés auxdits moyens formant antenne électromagnétique (10, 12).

16. Dispositif répondeur selon l'une quelconque des revendications 9 à 15, **caractérisé par** des moyens d'encapsulation (62, 66) encapsulant couramment ledit circuit intégré (20), ladite couche isolante (34), lesdites plages de liaison (22, 24) et lesdits moyens formant antenne (10, 12) pour former le dispositif répondeur (60).

17. Dispositif répondeur selon l'une quelconque des revendications 9 à 16, **caractérisé en ce que** les plages de liaison (22, 24) sont fabriquées dans un métal choisi dans le groupe constitué de l'or ou du cuivre.
